# EUROPÄISCHE PATENTSCHRIFT

(11) **EP 1 638 125 B1**
(45) Veröffentlichungstag und Bekanntmachung des Hinweises auf die Patenterteilung: **10.10.2007**
(21) Anmeldenummer: 05017889.6
(22) Anmeldetag: 17.08.2005
(51) Int. Cl.: H01H 85/046

(54) **Platine mit Leiterbahnsicherung**
Printed circuit board with conductor track fuse
Carte à circuits imprimés avec un tracé conducteur fusible

(30) Priorität: 15.09.2004 DE 102004044683
(43) Veröffentlichungstag der Anmeldung: 22.03.2006
(73) Patentinhaber: Patent-Treuhand-Gesellschaft für elektrische Glühlampen mbH, 81543 München (DE)
(72) Erfinder: Franck, Felix, Dr., 80333 München (DE)

(56) Entgegenhaltungen:
- EP-A- 0 370 572
- EP-A- 0 513 405
- EP-A- 1 045 625
- EP-A- 1 308 978
- US-A- 5 723 898

## Beschreibung

### Technisches Gebiet

Die Erfindung betrifft eine Platine mit einer Leiterbahnsicherung gemäß dem Oberbegriff des Patentanspruchs 1.

### Stand der Technik

Die Leiterbahnsicherung einer Platine hat die Aufgabe, bei einem anormalen Betriebszustand, insbesondere bei einem Kurzschluss, die Verbindung zur Spannungsversorgung schnell und zuverlässig zu unterbrechen. Damit soll verhindert werden, dass sich der Kurzschluss auf der Platine ausbreitet und weiteren Schaden anrichtet. Außerdem soll durch das frühzeitige Ansprechen der Leiterbahnsicherung vermieden werden, dass ein Netzschutzschalter ausgelöst wird.

Zu diesem Zweck wird häufig ein bestimmter Leiterbahnabschnitt auf der Platine als Schmelzsicherung ausgeführt. Dieser Leiterbahnabschnitt hat einen im Vergleich zu den anderen Leiterbahnen auf der Platine verengten Querschnitt, der bei Auftreten eines Kurzschlusses kontrolliert schmelzen und so den Stromkreis unterbrechen soll.

Ein Problem dabei ist, dass das beim Schmelzen und Verdampfen der Schmelzsicherung auftretende Plasma ein neues, niederohmig unter Netzspannung stehendes Kontaktpaar findet und dadurch unkontrolliert weiterbrennt. Auf diese Weise wird ein indirekter Kurzschluss ausgelöst, der meistens zwischen Lötstellen und/oder wesentlich breiteren Leiterbahnen brennt und aufgrund der größeren verfügbaren Metallmenge wesentlich mehr leitfähiges Plasma erzeugt als der eigentliche Kurzschluss und somit weiteren Schaden auf der Platine verursacht. Der Prozess schaukelt sich so lange auf, bis schließlich der Netzschutzschalter ausgelöst wird oder Rauch aus dem Gerät austritt. Je niederohmiger das anschließende Netzfilter ist, d.h. je höher die Nennleistung des Geräts ist, desto häufiger tritt der soeben beschriebene Fall ein.

Ein Lösungsversuch für dieses Problem findet sich in der EP 0 774 887 A2. Diese zeigt eine Leiterbahnsicherung, bei der zwei gegensinnig von Strom durchflossene Leiterbahnabschnitte möglichst parallel in einem geringen Abstand zueinander angeordnet sind, so dass die Leiterbahn insgesamt eine U-Form aufweist. Durch den geringen Abstand stehen die Magnetfelder im Bereich der Leitungsabschnitte in Wechselwirkung miteinander. Einer der Leiterbahnabschnitte hat einen verengten Querschnitt und schmilzt im Falle eines Kurzschlusses. Das dabei entstehende Plasma wird durch die Wechselwirkung der Magnetfelder vom benachbarten Leiterabschnitt ferngehalten und es kann ein Weiterbrennen des Plasmas vermieden werden.

Hiermit kann das eingangs geschilderte Problem jedoch nicht zuverlässig und für jede Anwendung gelöst werden. Vor allem bei dicht bestückten Platinen besteht die Gefahr, dass das Plasma zu anderen benachbarten Leiterbahnen überspringt, in denen noch kein Kurzschlussstrom fließt und die demzufolge auch kein (wie auch immer gepoltes) für die Abstoßung des Plasmas ausreichend starkes Magnetfeld haben. Außerdem wird es aus Platzgründen nicht immer möglich sein, diese U-förmige Leiterbahnsicherung auf jeder Platine unterzubringen.

Aus der EP 1 308 978 ist eine Leiterbahnsicherung bekannt, die auf einer der beiden Stromzuführenden Leitungen durch einen verengten Abschnitt gebildet wird. Dieser verengte Abschnitt ist in einem Hohlkörper angeordnet, der das beim Kurzschluß entstehende Plasma von der Zweiten stromführenden Leiterbahn abhalten soll. Um das Plasma zu steuern besitzt der Hohlkörper eine Öffnung, durch die das Plasma entweichen kann. Der Nachteil dieser Anordnung besteht darin, dass das Plasma nicht von der Platine weggelenkt wird und damit wiederum einen Kurzschluß verursachen kann.
EP 1 045 625 wiederum beschreibt eine Leiterbahnsicherung, die von beiden Stromführenden Leiterbahnen gebildet wird, indem beide Leiterbahnen eine verengte Stelle aufweisen die parallel zueinander verlaufen. Zwischen beiden Leiterbahnen ist direkt neben jeder Leiterbahn jeweils eine Ausnehmung in der Platine angeordnet. Der gesamte Bereich ist mit einer Schutzschicht abgedeckt. Bei einem Kurzschluß wird das verdampfende Plasma somit durch die Ausnehmung hindurch auf die andere Seite der Platine geleitet. Der Nachteil dieser Anordnung besteht darin, dass das Plasma auf die andere Seite der Platine geleitet wird. Da dies die Bauteileseite ist, kann eine weiterer Kurzschluß zwischen den Beinchen der dort liegenden Bauteile nicht sicher ausgeschlossen werden.
Problematisch an dieser Lösung ist die komplizierte Anbringung der Abdeckschicht und Herstellung der Aussparung in der Leiterbahn. Desweiteren kann unter der Abdeckschicht ein sich ungünstig auf die Unterbrechung des Kurzschlussstroms auswirkender Hitzestau entstehen.

In der DE 37 23 832 A1 ist eine Leiterbahnsicherung offenbart, bei der ebenfalls eine Schmelzsicherung verwendet wird, die einen in diesem Fall durch eine Aussparung verringerten Leiterbahnquerschnitt hat. Diese Stelle mit dem verringerten Querschnitt wird mit einem funkenlöschenden Medium abgedeckt. Außerdem soll die Aussparung in der Schmelzsicherung, die z.B. eine Bohrung sein und bis durch die Platine hindurchreichen kann, ein Abströmen der beim Schmelzen entstehenden Gase ermöglichen.

Auch bei dieser Lösung ist die komplizierte Anbringung der Abdeckschicht und Herstellung der Aussparung in der Leiterbahn problematisch. Auch hier kann unter der Abdeckschicht ein sich ungünstig auf die Unterbrechung des Kurzschlussstroms auswirkender Hitzestau entstehen.

### Darstellung der Erfindung

Der Erfindung liegt die Aufgabe zugrunde, die Betriebssicherheit der Platine mit einfachen Mitteln zu verbessern.

Diese Aufgabe wird erfindungsgemäß durch die Merkmale des Anspruchs 1 gelöst. Besonders vorteilhafte Ausführungen der Erfindung sind in den abhängigen Ansprüchen beschrieben.

Die erfindungsgemäße Platine hat eine Leiterbahnsicherung mit einer Schmelzsicherung und einer Barriere, nachfolgend Trennwand genannt, wobei die Trennwand sich zwischen den interessierenden Polen, d.h. zwischen der Schmelzsicherung und einer benachbarten Leiterbahn befindet, an der Netzspannung anliegt bzw. in denen der Kurzschlussstrom fließt. Dies ist meist die Platinenunterseite zwischen den beiden Netzpolen.

Auf der Seite, die der Schmelzsicherung zugewandt ist, ist die Trennwand mit einer als Diffusor wirkenden zusätzlichen isolierenden Ablenkfläche versehen, um das bei einem Schmelzen der Schmelzsicherung entstehende Plasma, das sich in Richtung der benachbarten Leiterbahn bewegt, von dieser weg abzulenken und den Plasmastrahl aufzuweiten.

Dadurch kann ein Ausbreiten und Überspringen des Plasmas auf benachbarte Leiterbahnen und somit ein indirekter Kurzschluss auf wirkungsvolle und einfache Weise verhindert werden.

Zum besseren Reflektieren und Ablenken des Plasmas ist bei einer bevorzugten Ausführungsform die Ablenkfläche eben ausgebildet und in Bezug auf die Trennwandebene schräg angestellt, wobei der Winkel so gewählt ist, dass das Plasma weg von der benachbarten Leiterbahn gelenkt wird und zudem eine leichte Herstellbarkeit gewährleistet ist.
In einer bevorzugten Ausführungsform wird für die Anstellung der Schrägfläche in Bezug zu jeweils der Trennwandebene und der Platinenfläche ein Winkel von 45° gewählt.

Die Schrägfläche kann an einem an der Trennwand befestigten Vorsprung ausgebildet oder in einem Stück mit der Trennwand geformt werden.

In einer bevorzugten Ausführungsform hat die Ablenkfläche die Form eines Keils oder Prismas, wobei eine Seitenfläche des Prismas an der Platine aufsitzt, und eine andere Seitenfläche des Prismas die Ablenkfläche ausbildet.

Für den Fall, dass sich die Gehäusewand des Gehäuses, in dem sich die Platine befindet, nur in geringem Abstand zur Platine mit den Leiterbahnen befindet, kann in einer weiteren Ausführungsform am gehäuseseitigen Endbereich der Trennwand eine weitere Ablenkfläche vorgesehen werden. Dies bewirkt, dass das Plasma, das von der ersten Ablenkfläche bereits reflektiert und abgelenkt wurde, auf diese zweite Ablenkfläche prallt und damit erneut reflektiert und abgelenkt wird, und zwar weg von der Trennwand.

Diese zweite, gehäuseseitige Ablenkfläche ist vorzugsweise genauso wie die erste Ablenkfläche als Schrägfläche ausgeformt.

Um zu verhindern, dass das Plasma die Trennwand umkriecht und um die Trennwand an der Platine zu befestigen, ragt in einer Ausführungsform ein Abschlussstück der Trennwand in eine Ausnehmung der Platine hinein und ist dort befestigt.

### Kurze Beschreibung der Zeichnungen

Nachstehend wird die Erfindung anhand von zwei Ausführungsbeispielen näher erläutert. Es zeigen:
- Figur 1: eine schematische Schnittdarstellung einer bevorzugten Ausführungsform einer Platine mit einer Leiterbahnsicherung mit einer Trennwand, die eine Ablenkfläche hat und
- Figur 2: eine schematische Schnittdarstellung einer weiteren Ausführungsform einer Platine mit einer Leiterbahnsicherung mit einer Trennwand, die zwei Ablenkflächen aufweist.

### Bevorzugte Ausführung der Erfindung

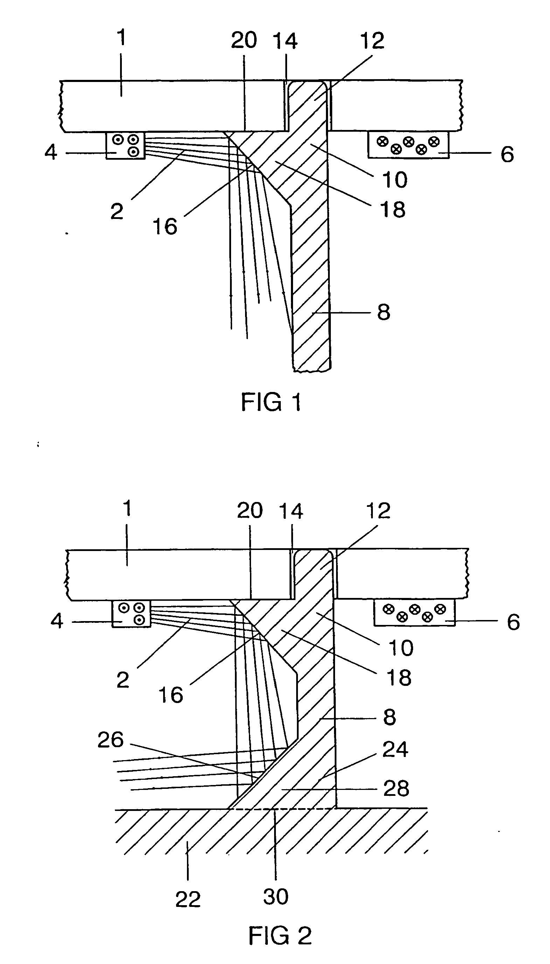

Figur 1 zeigt eine schematische Schnittdarstellung einer Platine 1 im Bereich einer Leiterbahnsicherung. Diese ist erfindungsgemäß derart ausgebildet, dass ein bei einem Kurzschluss entstehendes Plasma 2 von benachbarten Leiterbahnen 4, 6 weg abgelenkt wird. Derartige Platinen 1 werden beispielsweise bei Steuergeräten und Trafos für Lampen eingesetzt.

Leiterbahnen befinden sich üblicherweise an der Unterseite einer Platine 1, während die verschalteten elektronischen Bauteile an der Platinenoberseite befestigt sind. Eine Leiterbahn ist als Schmelzsicherung 4 ausgebildet ist und weist einen dünneren Querschnitt auf als eine weitere, benachbarte Leiterbahn 6.

Zwischen der Schmelzsicherung 4 und der benachbarten Leiterbahn 6 befindet sich eine Trennwand 8 aus isolierendem Material. Die Trennwand 8 steht in etwa in einem rechten Winkel zur Platinengroßfläche und hat an ihrem platinenseitigen Endbereich 10 ein Abschlussstück 12. Dieses ragt in eine Ausnehmung 14 der Platine 1 hinein und ist dort kraft- oder formschlüssig befestigt. Dabei sollten weder die Bestückbarkeit der Platine 1 noch die Montierbarkeit beeinträchtigt werden. Das Abschlussstück 12 kann sich über die ganze Länge des platinenseitigen Endbereichs 10 der Trennwand 8 oder nur über Bereiche erstrecken, und verhindert ein Umkriechen der Trennwand 8 durch das bei einem Kurzschluss entstehende Plasma 2.

Am platinenseitigen Endbereich 10 unterhalb (Ansicht nach Fig. 1) des in die Platine 1 ragenden Abschlussstücks 12 der Trennwand 8 ist an der der Schmelzsicherung 4 zugewandten Seite eine isolierende Ablenkfläche 16 ausgebildet. Diese ist in diesem Ausführungsbeispiel an einem prismenförmigen Vorsprung 18 ausgebildet, der sich vorzugsweise durchgehend über die komplette Länge der Trennwand 8 erstreckt. Der prismenförmige Vorsprung 18 ist einstückig mit der Trennwand 8 ausgebildet und sitzt mit einer an die Ablenkfläche 16 anschließenden Fläche 20 auf der Platine 1 auf, wobei die Ablenkfläche 16 schräg zur Platinenfläche verläuft. Die Ablenkfläche 16 des prismenförmigen Vorsprungs 18 verläuft, wie aus der Abbildung ersichtlich, in einem 45°-Winkel zur Platine 1 und zur Trennwand 8.

An der Ablenkfläche 16 wird das im Falle eines Kurzschlusses durch Schmelzen der Schmelzsicherung 4 entstehende Plasma 2 reflektiert und abgelenkt, und zwar derart, dass es sich von der Platine 1 und von der jenseits der Trennwand 8 angeordneten Leiterbahn 6 weg bewegt, und so ein Übergreifen des Plasmas 2 auf die Leiterbahn 6 verhindert ist.

In Figur 2 ist eine zweite bevorzugte Ausführungsform schematisch im Schnitt dargestellt. Bei diesem Ausführungsbeispiel ist eine Gehäusewand 22 eines Gehäuses, in dem die Platine 1 montiert ist, in nur geringem Abstand zur Platinenunterseite, also der Seite, an der sich die Leiterbahnen 4, 6 befinden, angeordnet.

Bei diesem Ausführungsbeispiel reicht die Trennwand 8 bis hin zur Gehäusewand 22 und ist an dieser befestigt oder einstückig mit dieser ausgeformt.

Am gehäuseseitigen Endbereich 24 der Trennwand 8 ist eine zweite, gehäuseseitige Ablenkfläche 26 angebracht oder einstückig mit der Trennwand 8 ausgeformt. Diese gehäuseseitige Ablenkfläche 26 befindet sich an der gleichen Seite der Trennwand 8 wie die platinenseitige Ablenkfläche 16, also an der der Schmelzsicherung 4 zugewandten Seite.

Ebenso wie die platinenseitige Ablenkfläche 16 kann die gehäuseseitige Ablenkfläche 26 als Prisma mit 45°-Winkeln in Bezug auf Platine 1 und Trennwand 8 ausgebildet sein, und sitzt mit einer an die Ablenkfläche 26 anschließenden Fläche 30 auf der Gehäusewand 22 auf oder ist -wie beim dargestellten Ausführungsbeispiel- einstückig mit der Gehäusewandung 22 ausgebildet. Die gehäuseseitige Ablenkfläche 26 ist um 90° zur platinenseitigen Ablenkfläche 16 versetzt.

Auf diese gehäuseseitige Ablenkfläche 26 prallt das von der platinenseitigen Ablenkfläche 16 umgelenkte Plasma 2 auf und wird dann so abgelenkt, dass es sich weg von der Trennwand 8 bewegt. Durch das zweimalige Umlenken wird das Plasma 2 noch effektiver als beim vorbeschriebenen Ausführungsbeispiel davon abgehalten, in Wechselwirkung mit der benachbarten Leiterbahn 6 zu treten, da es zusätzlich noch in eine entgegengesetzte Richtung umgelenkt wird und entlang der Gehäusewandung im Abstand zur Schmelzsicherung 4 in einen Bereich geleitet wird, in dem die Gefahr eines Übergreifens auf benachbarte Leiterbahnen minimal ist. Damit werden die aus der Sicherungsleiterbahn austretenden negativen Ionen im Plasma 2 nicht nur auf ihrem direkten Weg zum niederohmigen Gegenpol behindert, sondern zusätzlich auch noch auf einen möglichst langen Umweg geschickt, angetrieben durch ihren eigenen Impuls.

Selbstverständlich können anstelle der bei den vorbeschriebenen Ausführungsbeispielen verwendeten 45°-Anstellwinkeln auch andere Winkel verwendet werden.

Anstelle der in den Ausführungsformen verwendeten ebenen Ablenkflächen kann z.B. auch eine als Diffusor wirkende Hohlkehle ausgebildet sein, die eine elliptische oder parabolische Form aufweist.

Die Trennwand kann auch zwischen den in der EP 0774 887 A2 beschriebenen U-förmig angeordneten Leiterbahnabschnitten angeordnet sein.

Offenbart ist eine Platine 1 mit zwei benachbarten Leiterbahnen 4, 6, von denen eine als Schmelzsicherung 4 mit einem verengten Querschnitt ausgebildet ist, und zwischen denen sich eine isolierende Trennwand 8 befindet. Die Trennwand 8 verhindert, dass bei einem Kurzschluss durch Schmelzen der Schmelzsicherung 4 das Plasma 2 zur benachbarten Leiterbahn 6 übertritt. Desweiteren ist an der Trennwand 8 auf der der Schmelzsicherung 4 zugewandten Seite zumindest eine Ablenkfläche 16, 26 vorgesehen, an der das Plasma 2 weg von der Leiterbahn 6 abgelenkt wird.

### Bezugszeichenliste

- 1: Platine
- 2: Plasma
- 4: Schmelzsicherung
- 6: benachbarte Leiterbahn
- 8: Trennwand
- 10: platinenseitiger Endbereich
- 12: Abschlussstück
- 14: Ausnehmung
- 16: Ablenkfläche
- 18: Vorsprung
- 20: Fläche
- 22: Gehäusewand
- 24: gehäuseseitiger Endbereich
- 26: Ablenkfläche (gehäuseseitig)
- 28: Vorsprung (gehäuseseitig)
- 30: Fläche (gehäuseseitig)

## Patentansprüche

1. Platine (1) mit darauf angebrachten elektrischen Leiterbahnen zur elektrischen Verbindung von auf der Oberseite der Platine (1) montierten elektronischen Bauteilen, die auf der Unterseite der Platine mindestens eine Leiterbahnsicherung in Form einer Schmelzsicherung (4) hat, wobei bei Auftreten eines anormalen Betriebszustands, insbesondere eines elektrischen Kurzschlusses, der Stromkreis durch Schmelzen und Verdampfen der Schmelzsicherung (4) unterbrochen wird und beim Verdampfen der Schmelzsicherung (4) Plasma (2) entsteht, wobei sich zwischen der Schmelzsicherung (4) und einer benachbarten Leiterbahn (6) eine isolierende Trennwand (8) befindet und sich besagte Trennwand auf der Platinenunterseite befindet und mit ihrer der Schmelzsicherung zugewandten Hauptfläche im wesentlichen senkrecht. zur Platinenoberfläche steht, wobei an der Seite der Trennwand (8), die der Schmelzsicherung (4) zugewandt ist, zumindest eine Ablenkfläche (16) zum Ablenken und Reflektieren des Plasmas (2) ausgebildet ist, **dadurch gekennzeichnet, dass** die Ablenkfläche das auftreffende Plasma (2) weg von der Platine (1) nach unten ablenkt.

2. Platine (1) nach Anspruch 1, wobei die Ablenkfläche (16) eine Schrägfläche ist, die in Bezug auf die Trennwand (8) schräg angestellt ist.

3. Platine (1) nach Anspruch 2, wobei die Ablenkfläche (16) unter einem Winkel von 45° geneigt ist.

4. Platine (1) nach Anspruch 2, wobei die Ablenkfläche (16) durch einen Vorsprung (18) der Wandung (8) ausgebildet ist und der Vorsprung (18) an der Trennwand (8) befestigt oder einstückig mit dieser geformt ist, und sich über die gesamte Länge der Trennwand erstreckt.

5. Platine (1) nach Anspruch 4, wobei der Vorsprung (18) prismatisch ausgebildet ist.

6. Platine (1) nach Anspruch 5, wobei der prismatische Vorsprung (18) am platinenseitigen Endbereich (10) der Trennwand (8) ausgebildet ist und eine an die Schrägfläche anschließende Fläche (20) hat, die auf der Platine (1) aufsitzt.

7. Platine (1) nach einem der vorhergehenden Ansprüche, wobei ein Abschlussstück (12) der Trennwand (8) in eine Ausnehmung (14) der Platine (1) taucht.

8. Platine (1) nach einem der vorhergehenden Ansprüche mit einer zweiten Ablenkfläche (26), die das von der ersten Ablenkfläche (16) reflektierte Plasma (2) weg von der Trennwand (8) ablenkt.

9. Platine (1) nach Anspruch 8, wobei die Trennwand (8) an der Gehäusewand (22) eines die Platine (1) aufnehmenden Gehäuses angeformt ist und die zweite Ablenkfläche (26) am gehäuseseitigen Endbereich (24) der Trennwand (8) ausgeformt ist.

10. Platine (1) nach Anspruch 8, wobei die zweite Ablenkfläche (26) eine Schrägfläche ist, die in Bezug zur Trennwand (8) schräg angestellt ist.

11. Platine (1) nach Anspruch 10, wobei die Ablenkfläche (26) an einem prismatischen Vorsprung (28) ausgebildet ist.

12. Platine (1) nach Anspruch 11, wobei der prismatische Vorsprung (28) eine sich an die zweite Ablenkfläche (26) anschließende Fläche (30) hat, die auf der Gehäusewand (22) aufsitzt oder einstückig mit dieser verbunden ist.

## Claims

1. Printed circuit board (1) with electrical conductors provided thereon for electrically connecting electronic components mounted on the top of the printed circuit board (1), which has at least one conductor fuse in the form of a fusible link (4) on the underside of the printed circuit board, the circuit being interrupted by melting and evaporating of the fusible link (4) on the occurrence of an abnormal operating state, particularly of an electrical short circuit, and plasma (2) being produced during the evaporation of the fusible link (4), an insulating partition (8) being located between the fusible link (4) and an adjacent conductor (6) and said partition being located on the underside of the printed circuit board and its main surface which faces the fusible link being essentially perpendicular to the surface of the printed circuit board, at least one deflection surface (16) for deflecting and reflecting the plasma (2) being formed on the side of the partition (8) facing the fusible link (4), **characterized in that** the deflection surface deflects the impinging plasma (2) downwards away from the printed circuit board (1).

2. Printed circuit board (1) according to Claim 1, the deflection surface (16) being an inclined surface which is set at an angle with respect to the partition (8).

3. Printed circuit board (1) according to Claim 2, the deflection surface (16) being inclined at an angle of 45°.

4. Printed circuit board (1) according to Claim 2, the deflection surface (16) being formed by a projection (18) of the wall (8) and the projection (18) being attached to the partition (8) or formed of one piece with the latter and extending over the whole length of the partition.

5. Printed circuit board (1) according to Claim 4, the projection (18) being prismatically constructed.

6. Printed circuit board (1) according to Claim 5, the prismatic projection (18) being constructed at the end area (10) of the partition (8) at the printed circuit board side and having a surface (20) which adjoins the inclined surface and rests on the printed circuit board (1).

7. Printed circuit board (1) according to one of the preceding claims, wherein a terminating piece (12) of the partition (8) plunges into a recess (14) in the printed circuit board (1).

8. Printed circuit board (1) according to one of the preceding claims, comprising a second deflection surface (26) which deflects the plasma (2), which is reflected by the first deflection surface (16), away from the partition (8).

9. Printed circuit board (1) according to Claim 8, the partition (8) being formed on the housing wall (22) of a housing accommodating the printed circuit board (1) and the second deflection surface (26) being formed on the end area (24), of the partition (8) at the housing side.

10. Printed circuit board (1) according to Claim 8, the second deflection surface (26) being an inclined surface which is set at an angle with respect to the partition (8).

11. Printed circuit board (1) according to Claim 10, the deflection surface (26) being formed on a prismatic projection (28).

12. Printed circuit board (1) according to Claim 11, the prismatic projection (28) having a surface (30) which adjoins the second deflection surface (26) and which rests on the housing wall (22) or is joined to the latter in one piece.

## Revendications

1. Plaquette (1) à circuit imprimé, sur laquelle sont apposées des pistes conductrices électriques pour la liaison électrique de composants électroniques montés sur la face supérieure de la plaquette (1) à circuit imprimé, plaquette qui a sur la face inférieure au moins une sécurité de piste conductrice sous la forme d'un fusible (4), le circuit étant, lorsque apparaît un état de fonctionnement anormal, notamment un court-circuit électrique, interrompu par fusion et évaporation du fusible (4) et un plasma (2) se créant lors de l'évaporation du fusible (4), une cloison (8) isolante se trouvant entre le fusible (4) et une piste (6) conductrice voisine, et ladite cloison se trouvant sur la face inférieure de la platine et étant par sa surface principale tournée vers le fusible sensiblement perpendiculaire à la surface de la platine, une surface (16) de déviation et de réflexion du plasma (2) étant constituée du côté de la cloison (8) tournée vers le fusible (4), **caractérisée en ce que** la surface de déviation dévie vers le bas le plasma (2) incident en l'éloignant de la plaquette (1) à circuit imprimé.

2. Plaquette (1) à circuit imprimé suivant la revendication 1, dans laquelle la surface (16) de déviation est une surface inclinée qui est inclinée par rapport à la cloison (8).

3. Plaquette (1) à circuit imprimé suivant la revendication 2, dans laquelle la surface (16) de déviation est inclinée d'un angle de 45°.

4. Plaquette (1) à circuit imprimé, suivant la revendication 2, dans laquelle la surface (16) de déviation est constituée par une saillie (18) de la cloison (8) et la saillie (18) est fixée à la cloison (8) ou est d'un seul tenant avec celle-ci et s'étend sur toute la longueur de la cloison.

5. Plaquette (1) à circuit imprimé suivant la revendication 4, dans laquelle la saillie (18) est prismatique.

6. Plaquette (1) à circuit imprimé suivant la revendication 5, dans laquelle la saillie (18) prismatique est formée sur la partie (10) d'extrémité de la cloison (8) qui est du côté de la plaquette à circuit imprimé et a une surface (20) se raccordant à la surface inclinée et reposant sur la plaquette (1) à circuit imprimé.

7. Plaquette (1) à circuit imprimé suivant l'une des revendications précédentes, dans laquelle une pièce (12) de terminaison de la cloison (8) pénètre dans un évidement (14) de la plaquette (1) à circuit imprimé.

8. Plaquette (1) à circuit imprimé suivant l'une des revendications précédentes, ayant une deuxième surface (26) de déviation qui dévie le plasma (2) réfléchi par la première surface (16) de déviation en l'éloignant de la cloison (8).

9. Plaquette (1) à circuit imprimé suivant la revendication 8, dans laquelle la cloison (8) est formée sur la paroi (22) d'un boîtier recevant la plaquette (1) à circuit imprimé et la deuxième surface (26) de déviation est formée sur la partie (24) d'extrémité de la cloison (8) qui est du côté du boîtier.

10. Plaquette (1) à circuit imprimé suivant la revendication 8, dans laquelle la deuxième surface (26) de déviation est une surface inclinée qui est inclinée par rapport à la cloison (8).

11. Plaquette (1) à circuit imprimé suivant la revendication 10, dans laquelle la surface (26) de déviation est formée sur une saillie (28) prismatique.

12. Plaquette (1) à circuit imprimé suivant la revendication 11, dans laquelle la saillie (28) prismatique a une surface (30) se raccordant à la deuxième surface (26) de déviation s'appliquant à la paroi (22) de boîtier ou d'un seul tenant avec elle.
